# FASCICULE DE BREVET EUROPEEN

(11) **EP 0 930 507 B1**
(45) Date de publication et mention de la délivrance du brevet: **06.04.2005**
(21) Numéro de dépôt: 99400071.9
(22) Date de dépôt: 13.01.1999
(51) Int. Cl.: G01R 15/20

(54) **Agencement de mesure de courant alternatif ou continu**
Messanordnung für Wechselstrom oder Gleichstrom
Arrangement for measuring alternate current or direct current

(30) Priorité: 15.01.1998 FR 9800377
(43) Date de publication de la demande: 21.07.1999
(73) Titulaire: CHAUVIN ARNOUX, 75018 Paris (FR)
(72) Inventeur: Arnoux, Axel, 75018 Paris (FR); Genter, Claude, 75018 Paris (FR); Piaud, Didier, 92370 Chaville (FR)
(74) Mandataire: Berger, Helmut

(56) Documents cités:
- WO-A-90/11529
- US-A- 4 947 108

## Description

L'invention concerne un agencement de mesure de courant alternatif ou continu, du type comprenant des moyens générateurs d'un champ magnétique à partir du courant à mesurer, un dispositif capteur du champ magnétique engendré et un circuit de mesure qui détermine la valeur dudit courant.

On connaît déjà des agencements de mesure de ce type, qui utilisent en général une pince ampèremètrique ou un tore ouvrant ou non, qui se referme complètement sur le câble dans lequel circule le courant à mesurer.

Or, on sait que la présence de discontinuités dans le circuit magnétique, produites par l'entrefer, le bobinage, l'ouverture de la pince pour enserrer le câble de mesure, l'insertion du capteur ou analogue, crée des zones sur le tore qui présentent une sensibilité plus grande aux champs magnétiques d'origine externe et donc parasite en faussant ainsi la mesure du courant primaire.

Les moyens habituels pour diminuer ces influences extérieures consistent soit à réduire au maximum ces discontinuités, soit à modifier la géométrie des pièces présentes dans cette zone sensible, soit à ajouter un blindage dans le voisinage de cette zone, tel que cela est par exemple montré dans WO 90 11 529 A.

Ces différents moyens pour résoudre le problème posé par les discontinuités présentent les inconvénients majeurs d'être susceptibles de modifier les caractéristiques de l'agencement de mesure et d'ajouter des difficultés lors de sa fabrication.

La présente invention a pour but de proposer un agencement de mesure qui pallie les inconvénients de l'état de la technique qui viennent d'être énoncés en créant un agencement de mesure de courant alternatif ou continu du type comprenant un moyen générateur d'un champ magnétique à partir du courant à mesurer, un dispositif capteur du champ magnétique engendré, un circuit de mesure qui détermine la valeur de mesure Vs dudit courant et des moyens de réduction des influences extérieures produites sur la valeur de mesure établie par une grandeur parasite présente dans la zone de mesure, lesdits moyens de réduction des influences extérieures comprenant un dispositif capteur de la grandeur parasite et un circuit d'établissement d'un signal de correction Vc qui est appliqué au circuit de mesure, lequel agencement est caractérisé en ce que le dispositif capteur de la grandeur parasite est disposé dans le champ de la grandeur parasite de façon à présenter le même angle, par rapport aux lignes de champ de la grandeur parasite, que le dispositif capteur du champ magnétique engendré par le courant à mesurer, par rapport aux lignes de champ magnétique engendré par ce courant; et en ce que la grandeur parasite est une grandeur telle qu'un champ magnétique extérieur parasite ou la rémanence.

Selon d'autres caractéristiques avantageuses de l'invention
- lorsque la grandeur parasite est un champ magnétique extérieur parasite, le dispositif capteur comporte au moins un capteur de champ magnétique, disposé au voisinage de la zone sensible au champ magnétique extérieur parasité
- un tore magnétique entoure le conducteur dans lequel circule le courant à mesurer et comprend fun entrefer dans lequel est disposé le dispositif capteur du champ magnétique engendré par lie coursant à mesurer ;
- lorsque l'agencement est du type à annulation du champ magnétique engendré par ce courant et pourvu d'une bobine d'annulation de champ entourant le tore, le signal de correction Vc est appliqué à un amplificateur de courant monté dans le circuit de la bobine d'annulation de champ et qui fait partie du circuit de mesure ;
- le signal de correction Vc est appliqué à l'entrée d'un amplificateur qui produit en sortie la valeur de mesure Vs et qui fait partie du circuit de mesure ;
- le circuit d'établissement du signal de correction Vc comporte des moyens de mise à l'échelle de la valeur du champ de la grandeur parasite et d'application de cette valeur à l'état inversé à un point prédéterminé du circuit de mesure ;
- lorsque l'agencement est du type à mesure du champ magnétique engendré par ce courant, le signal de correction Vc est appliqué à l'entrée d'un amplificateur opérationnel monté dans le circuit de mesure
- la grandeur parasite peut être la rémanence ou être fonction de la température ambiante.

L'invention sera mieux comprise et d'autres buts, caractéristiques, détails et avantages de celle-ci apparaîtront plus clairement dans la description explicative qui va suivre faite en référence aux dessins schématiques annexés donnés uniquement à titre d'exemple illustrant deux modes de réalisation de l'invention et dans lesquels :
- la figure 1 est une vue synoptique d'un agencement de mesure de courant alternatif ou continu selon la présente invention ;
- la figure 2 illustre, à l'aide de graphiques l'effet de l'agencement selon l'invention ;
- la figure 3 montre, sous forme d'un schéma-blocs un agencement de mesure de courant par annulation du champ magnétique, selon la présente invention ; et
- la figure 4 montre, sous forme d'un schéma-blocs un agencement de mesure de courant par mesure du champ magnétique, selon la présente invention.

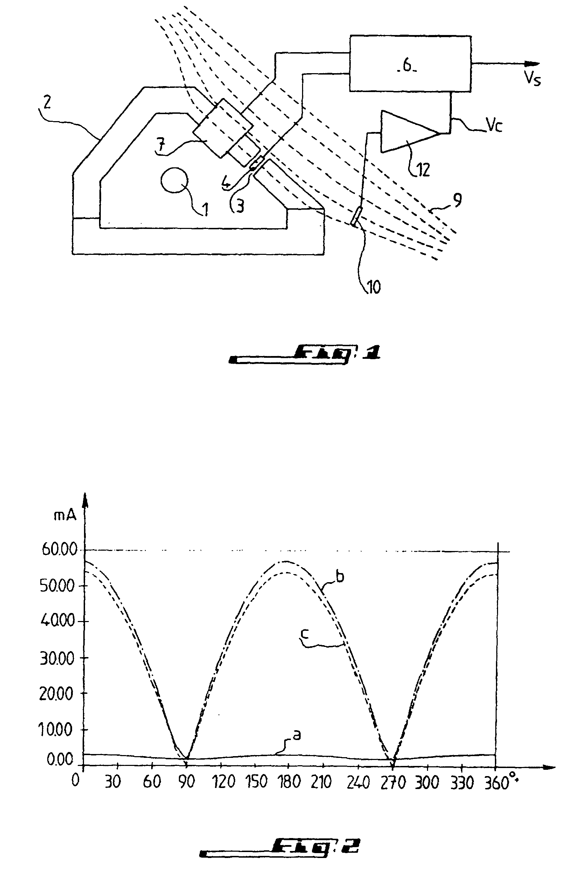

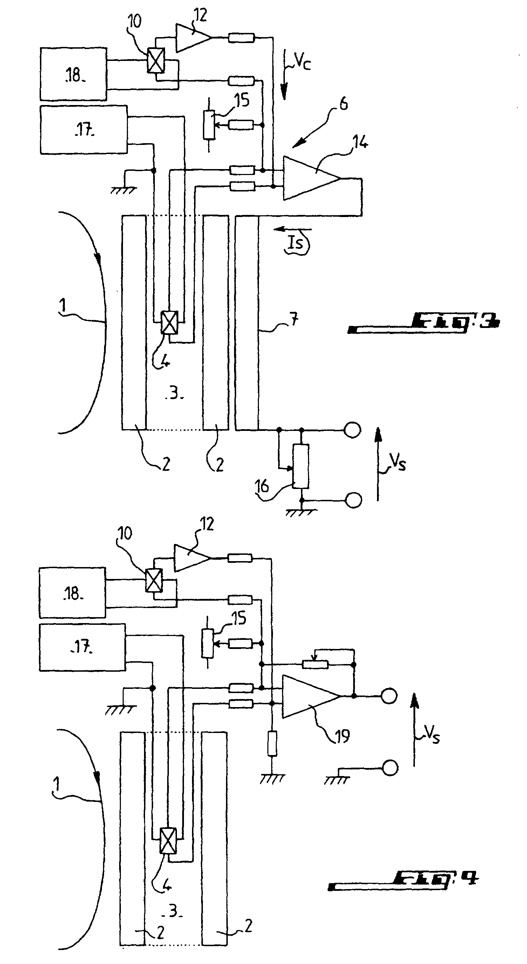

En se référant aux figures 1 et 2, on décrira ci-après tout d'abord le principe de la structure d'un agencement selon l'invention et l'effet qu'il produit.

Sur la figure 1 le conducteur dans lequel circule le courant à mesurer porte le numéro de référence 1. L'agencement de mesure de ce courant comprend un tore magnétique 2 qui entoure le conducteur 1 et est pourvu d'un entrefer 3 dans lequel est monté un capteur 4 du champ magnétique engendré par le courant à mesurer, dans le tore magnétique 2. Le capteur 4 produit un signal électrique qui est appliqué à un circuit électronique 6 destiné à produire le signal de mesure Vs représentatif du courant circulant dans le conducteur 1.

L'agencement de mesure est du type à annulation du champ magnétique engendré et comporte une bobine 7 enroulée autour du tore magnétique 2 et destinée à produire le champ magnétique à l'intérieur du tore, qui annule le champ magnétique produit par le courant à mesurer circulant dans le conducteur 1. La bobine est reliée au circuit 6.

Le tore magnétique est exposé à un champ magnétique extérieur parasite dont les lignes de champ sont représentées par des lignes interrompues 9. On constate que le champ extérieur est déformé au voisinage du tore.

Conformément à l'invention, un capteur de champ magnétique est disposé dans le champ parasite au voisinage de la zone sensible à ce champ. Comme on le voit sur la figure, le capteur 10 est disposé de façon à présenter le même angle par rapport aux lignes de champ parasite 9 que le capteur de mesure 4 par rapport au champ magnétique engendré par le courant à mesurer. Dans le cas représenté, le capteur 10 est placé sensiblement perpendiculairement aux lignes de champ 9.

Le capteur 10 est relié à un circuit électronique 12 de mise à niveau du signal produit pour que ce dernier puisse être appliqué, sous forme d'un signal de correction Vc au circuit de mesure 6.

La figure 2 illustre par trois courbes l'effet du dispositif de correction en montrant le courant résiduel mesuré en présence d'un champ uniforme extérieur parasite en fonction de l'angle entre une pince ampèremètrique et le champ extérieur. La courbe a indique le courant représenté par la valeur Vs avec correction et la courbe b cette valeur sans correction, la courbe c indiquant la valeur de correction Vc.

La figure 3 montre plus en détail l'agencement de la figure 1. Sur cette figure, on utilise les mêmes références que sur la figure 1 pour des composants qui sont identiques ou similaires dans les deux cas. On constate notamment que le signal Vc, après avoir été mis à l'échelle en 12 est appliqué aux deux entrées d'un amplificateur de courant 14 qui fait partie du circuit de mesure 6 de la figure 1. L'agencement de la figure 3 prévoit un potentiomètre 15 de réglage à zéro d'une des entrées de l'amplificateur de courant 14. La sortie de celui-ci est reliée à la bobine 7 et le signal de mesure Vs est disponible comme tension entre les bornes d'une résistance ajustable 16 montées en série avec la bobine 7. Les références 17 et 18 indiquent les alimentations en énergie électrique respectivement du capteur de mesure 4 et du capteur de détection du champ parasite 10.

La figure 4 illustre l'utilisation de l'invention dans un agencement de mesure de courant par mesure du champ magnétique. Dans ce cas, la valeur de correction Vc est appliquée aux deux entrées d'un amplificateur opérationnel 19 et le signal de mesure Vs est produit en sortie de cet amplificateur.

Concernant le fonctionnement de l'agencement selon l'invention, il importe de retenir que la valeur fournie par le capteur du champ parasite 10, après mise à l'échelle, vient s'ajouter en opposition à un point du circuit ou de la chaîne de mesure pour minimiser l'influence exercée par ce champ. Il est à noter que la réponse du capteur 10, pour une rotation circulaire du champ extérieur dans les trois axes x, y et z doit correspondre à celle de l'ensemble de mesure dans les mêmes conditions. Par exemple, pour un capteur du type Hall on obtiendra deux lobes en opposition de 180°. Il faudrait que la réponse de la correction soit en phase et de même amplitude. L'opposition des deux signaux annulera l'effet perturbateur du champ externe.

Il est à noter que le principe de correction des influences externes, qui vient d'être décrit, peut également être utilisé pour réduire la rémanence et les dérives de mesure en fonction de la température ambiante.

## Revendications

1. Agencement de mesure de courant alternatif ou continu du type comprenant un moyen (2) générateur d'un champ magnétique à partir du courant à mesurer, un dispositif capteur (4) du champ magnétique engendré, un circuit de mesure (6) qui détermine la valeur de mesure (Vs) dudit courant et des moyens de réduction des influences extérieures produites sur la valeur de mesure établie par une grandeur parasite présente dans la zone de mesure, lesdits moyens de réduction des influences extérieures comprenant un dispositif capteur (10) de la grandeur parasite et un circuit (12) d'établissement d'un signal de correction (Vc) qui est appliqué au circuit de mesure (6), **caractérisé en ce que** le dispositif capteur (10) de la grandeur parasite est disposé dans le champ de la grandeur parasite de façon à présenter le même angle, par rapport aux lignes de champ (9) de la grandeur parasite, que le dispositif capteur (4) du champ magnétique engendré par le courant à mesurer, par rapport aux lignes de champ magnétique engendré par ce courant, et **en ce que** la grandeur parasite est une grandeur telle qu'un champ magnétique extérieur parasite ou la rémanence.

2. Agencement selon la revendication 1, **caractérisé en ce que**, lorsque la grandeur parasite est un champ magnétique extérieur parasite, le dispositif capteur (10) comporte au moins un capteur de champ magnétique disposé au voisinage de la zone sensible au champ magnétique extérieur parasite.

3. Agencement selon la revendication 2, **caractérisé en ce qu'**il comprend un tore magnétique (2) entourant le conducteur (1) dans lequel circule le courant à mesurer et comprenant un entrefer (3) dans lequel est disposé le dispositif capteur (4) du champ magnétique engendré par le courant à mesurer.

4. Agencement de mesure de courant selon la revendication 3, du type à annulation du champ magnétique engendré par ce courant et pourvu d'une bobine d'annulation de champ (₇) entourant le tore (2), **caractérisé en ce que** le signal de correction (Vc) est appliqué à un amplificateur de courant (14) monté dans le circuit de la bobine d'annulation de champ (7) et qui fait partie du circuit de mesure (6).

5. Agencement de mesure de courant selon la revendication 1, **caractérisé en ce que** le signal de correction (Vc) est appliqué à l'entrée d'un amplificateur (19) qui produit en sortie la valeur de mesure (Vs) et qui fait partie du circuit de mesure (6).

6. Agencement de mesure de courant selon la revendication 1, **caractérisé en ce que** le circuit d'établissement du signal de correction (Vc) comporte des moyens (12) de mise à l'échelle de la valeur du champ de la grandeur parasite et d'application de cette valeur à l'état inversé à un point prédéterminé du circuit de mesure (6).

7. Agencement de mesure de courant selon la revendication 1 du type à mesure du champ magnétique engendré par ce courant, le signal de correction (Vc) est appliqué à l'entrée d'un amplificateur opérationnel (19) monté dans le circuit de mesure (6).

8. Agencement de mesure de courant selon la revendication 1, **caractérisé en ce que** la grandeur parasite peut être la rémanence ou être fonction de la température ambiante.

## Patentansprüche

1. Anordnung zum Messen von Wechsel- oder Gleichstrom, vom Typ mit einem Mittel (2) zum Erzeugen eines Magnetfelds aus dem zu messenden Strom, einer Vorrichtung (4) zum Erfassen des gebildeten Magnetfelds, einem Messkreis (6), der den Messwert (Vs) dieses Stroms bestimmt, und mit Mitteln zum Vermindern der auf den Messwert einwirkenden äußeren Einflüsse, welche durch eine im Messbereich vorhandene Störgröße erzeugt werden, wobei die genannten Mittel zum Vermindern der äußeren Einflüsse eine Vorrichtung (10) zum Erfassen der Störgröße und ein Schaltglied (12) zum Erzeugen eines Korrektursignals (Vc) enthalten, das an den Messkreis (6) angelegt wird, **dadurch gekennzeichnet, dass** die Erfassungsvorrichtung (10) für die Störgröße im Störfeld unter dem gleichen Winkel zu den Feldlinien (9) der Störgröße angeordnet ist wie die Erfassungsvorrichtung (4) für das durch den zu messenden Strom erzeugte Magnetfeld zu den Feldlinien des von diesem Strom erzeugten Magnetfelds, und dass die Störgröße eine Größe wie etwa ein äußeres Störmagnetfeld oder die Remanenz ist.

2. Anordnung nach Anspruch 1, **dadurch gekennzeichnet, dass** dann, wenn die Störgröße ein äußeres Störmagnetfeld ist, die Erfassungsvorrichtung (10) zumindest einen Magnetfeldfühler enthält, der benachbart zum gegenüber dem äußeren Störmagnetfeld empfindlichen Bereich angeordnet ist.

3. Anordnung nach Anspruch 2, **dadurch gekennzeichnet, dass** sie einen magnetischen Torus (2) enthält, der den Leiter (1) umgibt, in dem der zu messende Strom fließt, und der einen Luftspalt (3) aufweist, in dem die Erfassungsvorrichtung (4) für das vom zu messenden Strom erzeugte Magnetfeld angeordnet ist.

4. Anordnung zum Messen eines Stroms nach Anspruch 3, vom Typ mit Annullierung des durch den Strom erzeugten Magnetfelds und mit einer Feldannullierungsspule (7), welche den Torus (2) umgibt, **dadurch gekennzeichnet, dass** das Korrektursignal (Vc) an einen Stromverstärker (14) angelegt wird, der im Kreis der Feldannullierungsspule (7) angeordnet ist und zum Messkreis (6) gehört.

5. Anordnung zum Messen eines Stroms nach Anspruch 1, **dadurch gekennzeichnet, dass** das Korrektursignal (Vc) an den Eingang eines Verstärkers (19) angelegt wird, der am Ausgang den Messwert (Vs) erzeugt und zum Messkreis (6) gehört.

6. Anordnung zum Messen eines Stroms nach Anspruch 1, **dadurch gekennzeichnet, dass** das Glied zum Erstellen des Korrektursignals (Vc) Mittel (12) zur Normierung des Wertes des Felds der Störgröße und zum Anlegen dieses Werts im umgekehrten Zustand an einen vorbestimmten Punkt des Messkreises (6) enthält.

7. Anordnung zum Messen eines Stroms nach Anspruch 1, vom Typ zum Messen des von diesem Strom erzeugten Magnetfelds, wobei das Korrektursignal (Vc) an den Eingang eines Operationsverstärkers (19) angelegt wird, der im Messkreis (6) angeordnet ist.

8. Anordnung zum Messen eines Stroms nach Anspruch 1, **dadurch gekennzeichnet, dass** die Störgröße die Remanenz bilden oder Funktion von der Umgebungstemperatur sein kann.

## Claims

1. Arrangement for measuring an AC or DC current, of the type comprising a means (2) for generating a magnetic field from the current to be measured, a sensor device (4) for sensing the magnetic field generated, a measurement circuit (6) which determines the measurement value (Vs) of the said current and means for reducing the external influences on the established measurement value which are produced by a parasitic quantity present in the measurement zone, the said means for reducing the external influences comprising a sensor device (10) for sensing the parasitic quantity and a circuit (12) for establishing a correction signal (Vc) which is applied to the measurement circuit (6), **characterized in that** the sensor device (10) for sensing the parasitic quantity is placed in the parasitic quantity field so as to give the same angle with respect to the parasitic quantity field lines (9) as the sensor device (4) for sensing the magnetic field generated by the current to be measured with respect to the magnetic field lines generated by this current, and **in that** the parasitic quantity is a quantity such as a parasitic external magnetic field or the remanence.

2. Arrangement according to Claim 1, **characterized in that**, when the parasitic quantity is a parasitic external magnetic field, the sensor device (10) includes at least one magnetic-field sensor placed near the zone sensitive to the parasitic external magnetic field.

3. Arrangement according to Claim 2, **characterized in that** it comprises a magnetic torus (2) surrounding the conductor (1) in which the current to be measured flows and comprising an airgap (3) in which the sensor device (4) for sensing the magnetic field generated by the current to be measured is placed.

4. Current-measuring arrangement according to Claim 3, of the type with cancellation of the magnetic field generated by this current and provided with a field-cancelling coil (7) surrounding the torus (2), **characterized in that** the correction signal (Vc) is applied to a current amplifier (14) that is mounted in the circuit of the field-cancelling coil (7) and which is part of the measurement circuit (6).

5. Current-measuring arrangement according to Claim 1, **characterized in that** the correction signal (Vc) is applied to the input of an amplifier (19) which produces, as output, the measurement value (Vs) and forms part of the measurement circuit (6).

6. Current-measuring arrangement according to Claim 1, **characterized in that** the circuit for establishing the correction signal (Vc) includes means (12) for scaling the value of the parasitic quantity field and for applying this value in the inverted state at a predetermined point in the measurement circuit (6).

7. Current-measuring arrangement according to Claim 1, of the type for measuring the magnetic field generated by this current, and the correction signal (Vc) is applied to the input of an operational amplifier (19) mounted in the measurement circuit (6).

8. Current-measuring arrangement according to Claim 1, **characterized in that** the parasitic quantity may be the remanence or be a function of the ambient temperature.
